# EUROPEAN PATENT APPLICATION

(11) **EP 4 570 583 A1**
(43) Date of publication of application: **18.06.2025**
(21) Application number: 23854213.8
(22) Date of filing: 28.07.2023
(51) Int. Cl.: B60L 58/27, H01M 10/615, H02K 11/30

(54) **ELECTRIC ASSEMBLY AND VEHICLE PROVIDED WITH SAME**

(30) Priority: 18.08.2022 CN 202210994370
(71) Applicant: BYD Company Limited, Shenzhen, Guangdong 518118 (CN)
(72) Inventor: ZHANG, Xingchun, Shenzhen, Guangdong 518118 (CN); YU, Fengchuan, Shenzhen, Guangdong 518118 (CN)
(74) Representative: Wu, Ting
(86) International application number: PCT/CN2023/109765
(87) International publication number: WO 2024/037309

(57) **Abstract**

A vehicle, provided with an electric assembly, and comprising a box body, an N-line connecting assembly, a motor, an electric control module, and a direct-current connector. The box body comprises an electric control cavity. One end of the N-line connecting assembly is suitable for being connected between two battery packs that are connected in series. The motor comprises a three-phase winding, one end of the three-phase winding is a junction end, and the junction end is connected to the other end of the N-line connecting assembly. The electric control module comprises an IGBT module, the IGBT module comprises a three-phase bridge arm, and the other end of the three-phase winding is connected to a middle point of the three-phase bridge arm. A positive electrode of the direct-current connector is connected to the junction end, and a negative electrode of the direct-current connector is connected to the IGBT module and is suitable for being connected to negative electrodes of the battery packs.

## Description

### CROSS-REFERENCE TO RELATED APPLICATIONS

The present disclosure claims priority to and benefits of Chinese Patent Application No. 202210994370.6, filed with the China National Intellectual Property Administration on August 18, 2022 and entitled "ELECTRIC ASSEMBLY AND VEHICLE PROVIDED WITH SAME", which is incorporated herein by reference in its entirety.

### FIELD

The present disclosure relates to the field of vehicle technologies, and specifically, to an electric assembly and a vehicle provided with same.

### BACKGROUND

In the related art, charging and discharging efficiency of a battery pack is low in a low-temperature state, making electric energy of the battery pack not fully utilized. Therefore, in some electric assemblies, a positive temperature coefficient (PTC) heating member is used to heat the battery pack. However, the additional arrangement of the PTC heating member in the electric assemblies leads to an increased number of components and increased costs and volume of the electric assemblies.

### SUMMARY

The present disclosure is to resolve at least one of technical problems in the related art. Therefore, an objective of the present disclosure is to provide an electric assembly. In the electric assembly, self-heating of battery packs can be implemented, and a three-phase winding of a motor and bridge arms of an electric control module are also reused in self-heating circuits of the battery packs, which have advantages such as low costs, a small volume, and a small number of components.

The present disclosure further provides a vehicle provided with the foregoing electric assembly.

To achieve the foregoing objective, according to an embodiment of a first aspect of the present disclosure, an electric assembly is provided. The electric assembly includes a box, an N-line connecting assembly, a motor, an electric control module, and a direct-current connector. The box includes an electric control cavity.

One end of the N-line connecting assembly is adapted to connect between two battery packs connected in series. The motor includes a three-phase winding. One end of the three-phase winding is a junction end, and the junction end is connected to another end of the N-line connecting assembly. The electric control module is mounted in the electric control cavity. The electric control module includes an IGBT module. The IGBT module includes a three-phase bridge arm, and other ends of the three-phase winding are respectively connected to a midpoint of the three-phase bridge arm. A positive electrode of the direct-current connector is connected to the junction end, and a negative electrode of the direct-current connector is connected to the IGBT module and is adapted to connect to negative electrodes of the battery packs.

In the electric assembly according to this embodiment of the present disclosure, self-heating of the battery packs can be implemented, and the three-phase winding of the motor and bridge arms of the electric control module are also reused in self-heating circuits of the battery packs, which have advantages such as low costs, a small volume, and a small number of components.

According to some embodiments of the present disclosure, the electric assembly further includes a first capacitor. The first capacitor is mounted in the electric control cavity and is an X capacitor. One end of the first capacitor is connected to the positive electrode of the direct-current connector, and the other end of the first capacitor is connected to the negative electrode of the direct-current connector.

According to some embodiments of the present disclosure, the electric assembly further includes a second capacitor and a second capacitor contactor. The second capacitor is mounted in the electric control cavity and is an X capacitor. One end of the second capacitor is connected to the one end of the first capacitor, and the other end of the second capacitor is connected to the positive electrode of the direct-current connector. The second capacitor contactor is mounted in the electric control cavity. One end of the second capacitor contactor is connected to the one end of the second capacitor, and the other end of the second capacitor contactor is connected to the one end of the three-phase winding.

According to some embodiments of the present disclosure, the first capacitor is an X1 capacitor, and the second capacitor is an X2 capacitor.

According to some embodiments of the present disclosure, the electric assembly further includes a boost capacitor. The boost capacitor is mounted in the electric control cavity. One end of the boost capacitor is connected to the negative electrode of the direct-current connector, and the other end of the boost capacitor is connected to the other ends of the three-phase winding.

According to some embodiments of the present disclosure, the electric assembly further includes a capacitor housing. The first capacitor, the second capacitor, and the boost capacitor are integrated into the capacitor housing.

According to some embodiments of the present disclosure, the electric assembly further includes a negative output copper bus bar. The negative output copper bus bar is mounted in the capacitor housing. The negative output copper bus bar is shared by the first capacitor and the second capacitor.

According to some embodiments of the present disclosure, a number of wire harness fixing grooves are provided on the capacitor housing, and the number of wire harness fixing grooves are at least partially provided above the second capacitor.

According to some embodiments of the present disclosure, a number of cable tie holes are provided on the capacitor housing, and the cable tie holes are at least partially provided above the boost capacitor.

According to some embodiments of the present disclosure, the electric assembly further includes a positive fuse and a negative fuse. The positive fuse is mounted in the electric control cavity. One end of the positive fuse is connected to the positive electrode of the direct-current connector, and the other end of the positive fuse is connected to an upper bridge arm of each phase bridge arm. The negative fuse is mounted in the electric control cavity and located below the positive fuse. One end of the negative fuse is connected to the negative electrode of the direct-current connector, and the other end of the negative fuse is connected to a lower bridge arm of each phase bridge arm.

According to some embodiments of the present disclosure, the electric assembly further includes a power supply module. The box further includes a power supply cavity. The power supply cavity is provided below the electric control cavity, and the power supply module is arranged in the power supply cavity.

According to some embodiments of the present disclosure, a bracket is arranged in the box. The bracket divides the box into the electric control cavity on an upper part and the power supply cavity on a lower part. A number of shielding ribs extending facing the power supply cavity are arranged on the bracket. The shielding ribs form a shielding cavity. The shielding cavity is configured to mount devices forming the power supply module.

According to some embodiments of the present disclosure, the box further includes a bottom plate. The bottom plate is configured to block an opening below the power supply cavity.

According to some embodiments of the present disclosure, the motor includes a casing and an end cover. The three-phase winding is arranged in the casing. The end cover is arranged at one end of the casing and is configured to block the casing. An opening for the N-line connecting assembly to pass through is provided on the end cover.

According to some embodiments of the present disclosure, the N-line connecting assembly includes an N line, an N-line adapter, an N-line nose, and an N-line socket. One end of the N line is connected to the one end of the three-phase winding. One end of the N-line adapter is connected to the one end of the N line. The other end of the N-line adapter passes through the opening and is connected to one end of the N-line nose. One end of the N-line socket is connected to the other end of the N line, and the other end of the N-line socket is connected to an N-line copper bus bar of the electric control module. The N-line copper bus bar passes through a Hall. The Hall is connected to the electric control module through a signal cable.

According to some embodiments of the present disclosure, an insertion groove is provided at the one end of the casing close to the end cover. The insertion groove is provided close to the electric control cavity. The N-line socket is inserted into the insertion groove and fixedly connected to the casing.

According to some embodiments of the present disclosure, the electric assembly further includes a liquid channel cover plate. The liquid channel cover plate is provided with a first liquid channel. The electric control cavity is provided with a second liquid channel and a third liquid channel. The liquid channel cover plate is connected to the box and blocks the second liquid channel and the third liquid channel. The first liquid channel is in communication with the second liquid channel and the third liquid channel. The second liquid channel is adapted to communicate with a liquid inlet pipe, and the third liquid channel is adapted to communicate with a liquid outlet pipe. A coolant in the second liquid channel flows into the first liquid channel, to dissipate heat for the IGBT module, and the coolant in the first liquid channel flows into the third liquid channel, to dissipate heat for the power supply module.

According to some embodiments of the present disclosure, the electric assembly further includes a sealing ring. A sealing groove surrounding the first liquid channel is provided on the liquid channel cover plate. The sealing ring is arranged in the sealing groove. The IGBT module compresses the sealing ring, and the sealing ring fills a gap between the liquid channel cover plate and the IGBT module.

According to some embodiments of the present disclosure, the third liquid channel includes a transition section and an annular section. The transition section is in communication with the first liquid channel. The annular section surrounds the power supply module and dissipates heat for the power supply module. One end of the annular section is connected to the other end of the transition section, and a liquid outlet hole is provided at the other end of the annular section. A depth of the annular section is greater than a depth of the second liquid channel and a depth of the transition section.

According to some embodiments of the present disclosure, the power supply module includes a power supply power board. The power supply power board is mounted in the power supply cavity. A number of devices are mounted on the power supply power board. The number of devices include a transformer, a transformer inductor, a number of MOS transistors, an AC inductor, and a DC inductor. The transformer and the transformer inductor are arranged spaced away. The number of MOS transistors are respectively arranged on two opposite sides of the transformer and the transformer inductor. The AC inductor and the DC inductor are respectively arranged on the two opposite sides of the transformer and the transformer inductor. The third liquid channel surrounds the transformer and the transformer inductor, and the number of MOS transistors are located on two opposite sides of the third liquid channel and exchange heat with the third liquid channel.

According to some embodiments of the present disclosure, the power supply cavity is provided with a number of MOS transistor cavities, an AC inductor cavity, and a DC inductor cavity. The AC inductor extends into the AC inductor cavity. The DC inductor extends into the DC inductor cavity. The number of MOS transistors extend into the number of MOS transistor cavities in a one-to-one correspondence.

According to some embodiments of the present disclosure, the electric control module includes a control board and a driving board. The driving board is arranged below the control board. The IGBT module is arranged on the driving board, and the IGBT module is connected to the control board. The electric assembly further includes a shielding plate. The shielding plate is arranged between the driving board and the control board.

According to an embodiment of a second aspect of the present disclosure, a vehicle is provided. The vehicle includes the electric assembly according to the embodiments of the first aspect of the present disclosure.

In the vehicle according to this embodiment of the second aspect of the present disclosure, the electric assembly according to the embodiments of the first aspect of the present disclosure is used, so that self-heating of battery packs can be implemented, and a three-phase winding of a motor and bridge arms of an electric control module are also reused in self-heating circuits of the battery packs, which have advantages such as low costs, a small volume, and a small number of components.

The additional aspects and advantages of the present disclosure will be provided in the following description, some of which will become apparent from the following description or may be learned from practices of the present disclosure.

### BRIEF DESCRIPTION OF THE DRAWINGS

The foregoing and/or additional aspects and advantages of the present disclosure will become apparent and comprehensible in the embodiment description made with reference to the following drawings.
FIG. 1 is a schematic structural diagram of an electric assembly according to an embodiment of the present disclosure;
FIG. 2 is an exploded view of an electric assembly according to an embodiment of the present disclosure;
FIG. 3 is an exploded view of an electric control cavity of a box of an electric assembly according to an embodiment of the present disclosure;
FIG. 4 is a schematic structural diagram of a capacitor housing of an electric assembly according to an embodiment of the present disclosure;
FIG. 5 is a schematic structural diagram of an electric control cavity of a box of an electric assembly according to an embodiment of the present disclosure;
FIG. 6 is an exploded view of a power supply cavity of a box of an electric assembly according to an embodiment of the present disclosure;
FIG. 7 is a schematic structural diagram of a power supply cavity of a box of an electric assembly according to an embodiment of the present disclosure;
FIG. 8 is a cross-sectional view of an electric assembly according to an embodiment of the present disclosure;
FIG. 9 is a cross-sectional view of an electric assembly from another perspective according to an embodiment of the present disclosure;
FIG. 10 is a schematic structural diagram of a liquid channel cover plate of an electric assembly according to an embodiment of the present disclosure;
FIG. 11 is a schematic diagram of a circuit of an electric assembly according to an embodiment of the present disclosure;
FIG. 12 is a schematic diagram of a layout of an electric control cavity of an electric assembly according to an embodiment of the present disclosure; and
FIG. 13 is a schematic block diagram of a vehicle according to an embodiment of the present disclosure.

In the drawings:
electric assembly 1, battery pack 2, and capacitor housing 3;
box 100, bracket 101, shielding rib 102, shielding cavity 103, electric control cavity 110, liquid channel cover plate 120, first liquid channel 130, second liquid channel 140, third liquid channel 150, transition section 151, annular section 152, liquid inlet pipe 160, liquid outlet pipe 170, sealing ring 180, power supply cavity 190, MOS transistor cavity 191, AC inductor cavity 192, and DC inductor cavity 193;
motor 200, winding 210, N-line nose 220, casing 230, end cover 240, N-line connecting assembly 250, N-line adapter 251, N line 252, N-line socket 253, opening 260, and insertion groove 270;
electric control module 300, driving board 310, control board 320, shielding plate 330, IGBT module 340, bridge arm 350, upper bridge arm 351, and lower bridge arm 352;
direct-current connector 400, positive fuse 410, and negative fuse 420;
first capacitor 500, negative output copper bus bar 510, second capacitor 600, second capacitor contactor 610, and boost capacitor 700;
power supply module 800, bottom plate 810, transformer 820, transformer inductor 830, MOS transistor 840, AC inductor 850, DC inductor 860, power supply power board 870, pressing plate 900, wire harness fixing groove 910, and cable tie hole 920; and vehicle 1000.

### DETAILED DESCRIPTION

Embodiments of the present disclosure are described in detail below with reference to exemplary embodiments of accompanying drawings.

In the description of the present disclosure, it should be understood that, orientation or position relationships indicated by the terms such as "center", "longitudinal", "transverse", "length", "width", "thickness", "on", "below", "front", "back", "left", "right", "vertical", "horizontal", "top", "bottom", "inside", "outside", "clockwise", "anticlockwise", "axial direction", "radial direction", and "circumferential direction" are based on orientation or position relationships shown in the drawings, and are used only for ease and brevity of illustration and description of the present disclosure, rather than indicating or implying that the mentioned device or component necessarily has a particular orientation or is necessarily constructed and operated in a particular orientation. Therefore, such terms should not be construed as a limitation on the present disclosure.

In the description of the present disclosure, "a plurality of/a number of" means two or more than two.

An electric assembly 1 according to an embodiment of the present disclosure is described below with reference to the accompanying drawings.

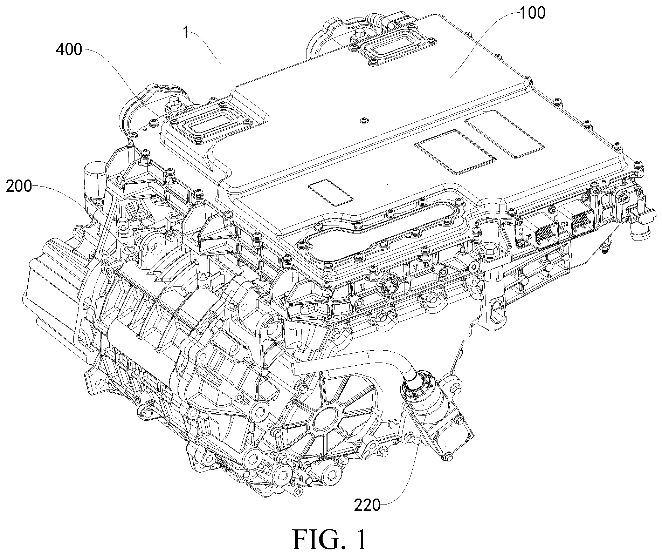

As shown in FIG. 1 to FIG. 12 (where an arrow A indicates a first direction, and an arrow B indicates a second direction), the electric assembly 1 according to this embodiment of the present disclosure includes a box 100, an N-line connecting assembly 250, a motor 200, an electric control module 300, and a direct-current connector 400.

The box 100 includes an electric control cavity 110. The motor 200 includes a three-phase winding 210. One end 2101 of the three-phase winding 210 is a junction end, and the junction end is connected to the N-line connecting assembly 250. One end 2501 of the N-line connecting assembly 250 is adapted to connect between two battery packs 2 connected in series. The electric control module 300 is mounted in the electric control cavity 110. The electric control module 300 includes an IGBT module 340. For example, the electric control module 300 includes a driving board 310 and a control board 320. The driving board 310 is arranged below the control board 320. Optionally, a shielding plate 330 is further arranged between the driving board 310 and the control board 320. Optionally, the IGBT module 340 is arranged on the driving board 310, and the IGBT module 340 is connected to the control board 320. The IGBT module 340 includes a three-phase bridge arm 350. Other ends 2102 of the three-phase winding 210 are respectively connected to a midpoint of the three-phase bridge arm 350. A positive electrode 4001 of the direct-current connector 400 is connected to the junction end. For example, the positive electrode 4001 of the direct-current connector 400 is connected to a three-phase upper bridge arm 351. A negative electrode 4002 of the direct-current connector 400 is connected to the IGBT module 340 and is adapted to connect to negative electrodes of the battery packs 2. For example, the negative electrode 4002 of the direct-current connector 400 is connected to a three-phase lower bridge arm 352.

It should be noted that, the other ends 2102 of the three-phase winding 210 are respectively connected to the midpoint of the three-phase bridge arm 350, which includes that the other ends 2102 of the three-phase winding 210 are respectively connected between the upper bridge arm 351 and the lower bridge arm 352 of the three-phase bridge arm 350, rather than that the other ends 2102 of the three-phase winding 210 are respectively connected to a middle position of the three-phase bridge arm 350.

In the electric assembly 1 according to this embodiment of the present disclosure, the electric control module 300 is mounted in the electric control cavity 110, the electric control module 300 includes the driving board 310 and the control board 320, the driving board 310 is arranged below the control board 320, and the shielding plate 330 is further arranged between the driving board 310 and the control board 320. In this way, the shielding plate 330 can attenuate electromagnetic interference of the driving board 310 to the control board 320, thereby avoiding fluctuation of a control signal of the control board 320, and improving reliability of the control signal of the control board 320.

According to some embodiments of the present disclosure, the IGBT module 340 is arranged on the driving board 310. The IGBT module 340 includes the three-phase bridge arm 350, and the IGBT module 340 is connected to the control board 320. For example, each phase bridge arm 350 includes an upper bridge arm 351 and a lower bridge arm 352. The three-phase upper bridge arm 351 is spliced and then connected to a first control interface of the control board 320, and the three-phase lower bridge arm 352 is spliced and then connected to a second control interface of the control board 320.

Because the three-phase upper bridge arm 351 is controlled by an electrical signal sent from the first control interface, the three-phase upper bridge arm 351 is simultaneously turned on or simultaneously turned off. Because the three-phase lower bridge arm 352 is controlled by an electrical signal sent from the second control interface, the three-phase lower bridge arm 352 is simultaneously turned on or simultaneously turned off. In addition, a status of the three-phase upper bridge arm 351 may remain opposite to a status of the three-phase lower bridge arm 352, that is, the electrical signal of the first control interface may be opposite to the electrical signal of the second control interface.

In other words, the motor 200 is a three-phase motor, and the motor 200 may be a driving motor or an electric generator. The three-phase winding 210 is used in the electric assembly 1, and the three-phase winding 210 is connected to the three-phase bridge arm 350 in a one-to-one correspondence, so that a probability of generating a ripple current in a circuit of the electric assembly 1 can be reduced, thereby ensuring stability of heating voltages and charging voltages of the battery packs 2, and improving quality of electric energy.

In addition, the one end 2101 of the three-phase winding 210 is the junction end, and the junction end is connected to the N-line connecting assembly 250. The one end 2501 of the N-line connecting assembly 250 is adapted to connect between the two battery packs 2 connected in series. The other ends 2102 of the three-phase winding 210 are respectively connected to the midpoint of the three-phase bridge arm 350. The positive electrode 4001 of the direct-current connector 400 is connected to the three-phase upper bridge arm 351, and the negative electrode 4002 of the direct-current connector 400 is connected to the three-phase lower bridge arm 352. The positive electrode 4001 of the direct-current connector 400 is connected to positive electrodes of the two battery packs 2 connected in series, and the negative electrode 4002 of the direct-current connector 400 is connected to the negative electrodes of the two battery packs 2 connected in series.

For example, in a positive half cycle of a fundamental wave cycle, when the upper bridge arms 351 are turned on and the lower bridge arms 352 are turned off, one of the two battery packs 2 discharges, a loop is formed through an IGBT of the upper bridge arms 351, and a current of the one of the two battery packs 2 flows through the upper bridge arms 351 to charge the three-phase winding 210. When the lower bridge arms 352 are turned on and the upper bridge arms 351 are turned off, the three-phase winding 210 freewheels to charge the other of the two battery packs 2, and then a loop is formed through diodes of the lower bridge arms 352.

In a negative half cycle of the fundamental wave cycle, when the lower bridge arms 352 are turned on and the upper bridge arms 351 are turned off, the other of the two battery packs 2 discharges to the three-phase winding 210, a loop is formed through an IGBT of the lower bridge arms 352, and a current of the other of the two battery packs 2 flows through the upper bridge arms 351 to charge the three-phase winding 210. When the upper bridge arms 351 are turned on and the lower bridge arms 352 are turned off, the three-phase winding 210 freewheels to charge the one of the two battery packs 2, and then a loop is formed diodes of the upper bridge arms 351.

The upper bridge arms 351 and the lower bridge arms 352 are controlled to operate at a high on/off frequency, and the two battery packs 2 charge and discharge each other through current oscillation, so that internal resistance of the two battery packs 2 generates heat, thereby implementing self-heating of the battery packs 2. A current amount between a junction point of the three-phase winding 210 and the battery packs 2 may be monitored by a Hall.

In this way, in a low-temperature environment, the battery packs 2 can perform self-heating, so that electricity supply efficiency of the battery packs 2 can be improved. For example, during traveling of a vehicle, the battery packs 2 can perform self-heating, so that the battery packs 2 are maintained in an operating state in which electricity is supplied at high efficiency. In addition, when the battery packs 2 are charged, the battery packs 2 can first perform self-heating, thereby improving charging efficiency. There is no need to additionally arrange a PTC heating member in the electric assembly 1, which reduces costs, reduces a volume, and reduces the number of components. In addition, compared with an electric assembly that heats battery packs by using a PTC heating member, the electric assembly 1 in the present disclosure consumes less electricity for the battery packs 2, thereby helping improve the service life of the vehicle.

In addition, the three-phase winding 210 of the motor 200 and the bridge arms 350 of the electric control module 300 are reused in self-heating circuits of the battery packs 2, so that utilization of components of the electric assembly 1 is improved, and the number of components is reduced. In this way, a volume of the electric assembly 1 is smaller, and costs are lower.

In this way, in the electric assembly 1 according to this embodiment of the present disclosure, self-heating of the battery packs 2 can be implemented, and the three-phase winding 210 of the motor 200 and the bridge arms 350 of the electric control module 300 are also reused in the self-heating circuits of the battery packs 2, which have advantages such as low costs, a small volume, and a small number of components.

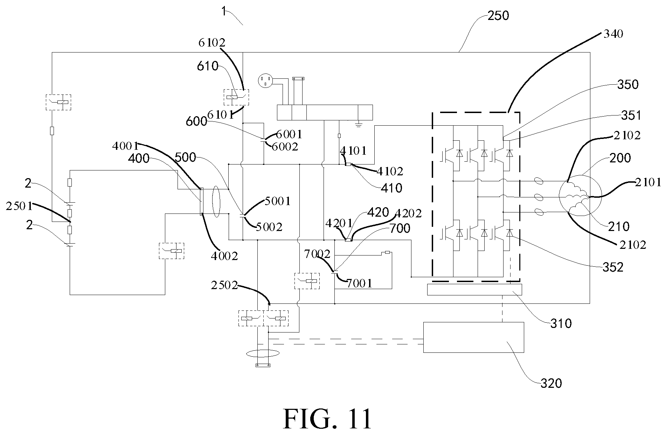

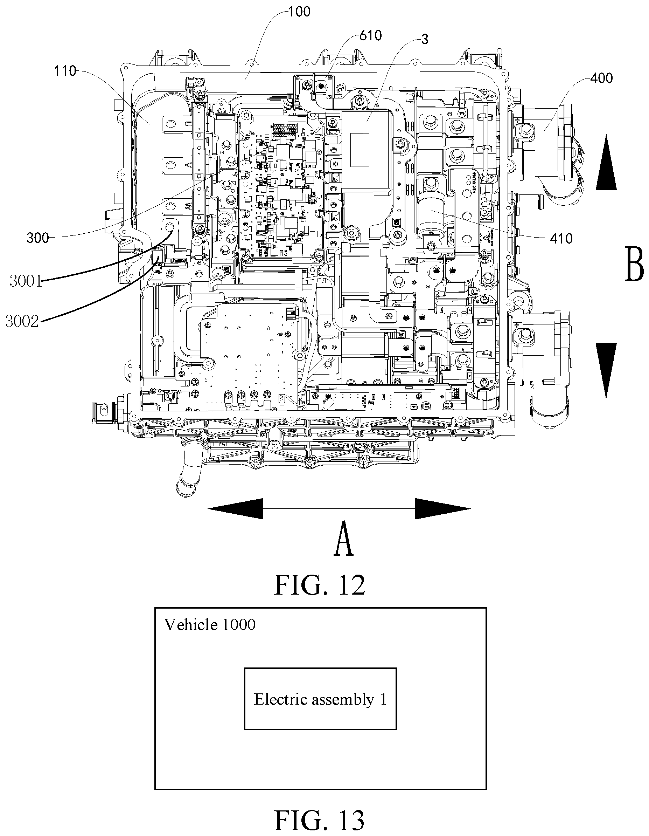

According to some specific embodiments of the present disclosure, as shown in FIG. 11 and FIG. 12, the electric assembly 1 further includes a first capacitor 500. The first capacitor 500 is mounted in the electric control cavity 110 and is an X capacitor. The first capacitor 500 is located between the direct-current connector 400 and the electric control module 300 in the first direction. The electric control module 300 extends in the second direction. The first direction is orthogonal to the second direction. One end 5001 of the first capacitor 500 is connected to the positive electrode 4001 of the direct-current connector 400, and the other end 5002 of the first capacitor 500 is connected to the negative electrode 4002 of the direct-current connector 400.

When the battery pack 2 supplies electricity to the bridge arm 350 of a control unit, a current of the battery pack 2 flows through the direct-current connector 400 and the first capacitor 500, and the first capacitor 500 absorbs a ripple current output by the battery pack 2, and filters the output current of the battery pack 2, to ensure stability of a voltage for supplying electricity to the bridge arm 350.

When the battery pack 2 is charged, a current input to the battery pack 2 first flows through the first capacitor 500, and the first capacitor 500 may absorb a ripple current in the current input to the battery pack 2, so that a charging voltage of the current flowing to the battery pack 2 is stable.

In this way, an overall distance from the first capacitor 500 to the direct-current connector 400 and the electric control module 300 is shorter; the first capacitor 500, the direct-current connector 400, and the electric control module 300 are more compact; and a connection among the first capacitor 500, the direct-current connector 400, and the electric control module 300 is more convenient, a wiring distance is shorter, and electrical connection reliability is higher. In this way, integration of the electric assembly 1 is improved, a volume of the electric control cavity 110 can be smaller, and the volume of the electric assembly 1 is also reduced.

According to some specific embodiments of the present disclosure, as shown in FIG. 11 and FIG. 12, the electric assembly 1 further includes a second capacitor 600 and a second capacitor contactor 610.

The second capacitor 600 is mounted in the electric control cavity 110 and is an X capacitor. The second capacitor 600 is located between the direct-current connector 400 and the electric control module 300 in the first direction, and the second capacitor 600 is located above the first capacitor 500. One end 6001 of the second capacitor 600 is connected to the one end 5001 of the first capacitor 500, and the other end 6002 of the second capacitor 600 is connected to the positive electrode 4001 of the direct-current connector 400. The second capacitor contactor 610 is mounted in the electric control cavity 110. The second capacitor contactor 610 is located between an inner wall of the electric control cavity 110 and the electric control module 300 in the second direction. The second capacitor contactor 610 is adjacent to a side of the electric control module 300 facing the second capacitor 600 in the first direction. One end 6101 of the second capacitor contactor 610 is connected to the one end 6001 of the second capacitor 600, and the other end 6102 of the second capacitor contactor 610 is connected to the one end 2101 of the three-phase winding 210.

In other words, the first capacitor 500 and the second capacitor 600 are connected in series, and the first capacitor 500 and the second capacitor 600 connected in series are connected to the positive electrode 4001 and the negative electrode 4002 of the direct-current connector 400. The first capacitor 500 and the second capacitor 600 can absorb a ripple current together, to achieve stability of the output voltage of the battery pack 2 and the charging voltage input to the battery pack 2. In addition, the second capacitor 600 can be used to eliminate differential-mode interference.

The second capacitor contactor 610 is arranged, so that whether the second capacitor 600 comes into communication with the junction end of the three-phase winding 210 can be controlled. When the battery pack 2 is boosted and charged or performs self-heating, the second capacitor contactor 610 may be conducted, so that the second capacitor 600 comes into communication with the junction end of the three-phase winding 210. In this way, the second capacitor 600 can absorb a differential-mode current between the junction end of the three-phase winding 210 and the battery pack 2, to reduce a high-frequency differential-mode current component between the positive electrode and the negative electrode of the direct-current connector 400, and reduce a risk of high-frequency current saturation of a magnetic ring at a specific frequency as much as possible.

In this way, an overall distance from the second capacitor 600 to the second capacitor contactor 610, the first capacitor 500, the direct-current connector 400, and the electric control module 300 is shorter; the second capacitor 600, the second capacitor contactor 610, the first capacitor 500, the direct-current connector 400, and the electric control module 300 are more compact; and a connection among the second capacitor 600, the second capacitor contactor 610, the first capacitor 500, the direct-current connector 400, and the electric control module 300 is more convenient, a wiring distance is shorter, and electrical connection reliability is higher. In this way, the integration of the electric assembly 1 is improved, the volume of the electric control cavity 110 can be smaller, and the volume of the electric assembly 1 is also reduced.

According to some specific embodiments of the present disclosure, the first capacitor 500 is an X1 capacitor, and the second capacitor 600 is an X2 capacitor. High-voltage resistance of the first capacitor 500 ranges from 2.5 KV to 4 KV, and high-voltage resistance of the second capacitor 600 is not greater than 2.5 KV

The first capacitor 500 is a capacitor that has a voltage-stabilizing and filtering function when the battery pack 2 supplies electricity to the IGBT of the bridge arms 350 of the control unit. During traveling of the vehicle, the IGBT has high power when converting a current. Therefore, a high-voltage resistance range of the first capacitor 500 needs to be larger.

The second capacitor 600 is configured to absorb a differential-mode current on a N line 252 when the battery pack 2 performs self-heating. It can be learned from FIG. 1 to FIG. 11 that, the second capacitor 600 is connected to the N line 252 through the second capacitor contactor 610. When the battery pack 2 performs self-heating, the N line 252 is conducted. Because power of the battery pack 2 for self-heating is not higher than the power of the IGBT when the IGBT converts the current during the traveling of the vehicle, a high-voltage resistance range of the second capacitor 600 may be smaller than the high-voltage resistance range of the first capacitor 500.

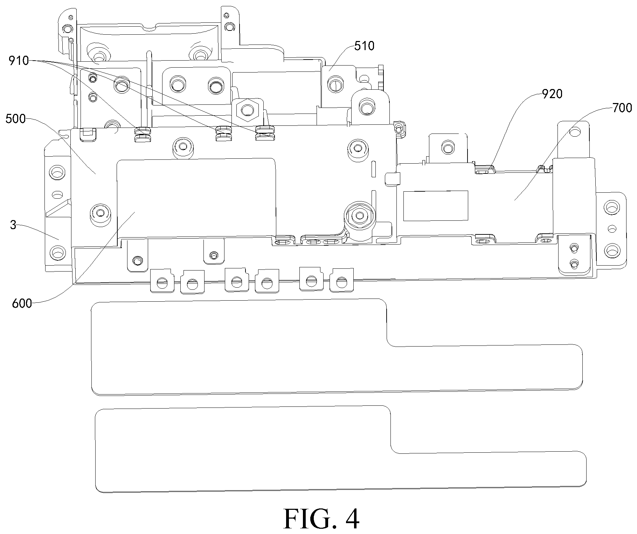

According to some specific embodiments of the present disclosure, as shown in FIG. 4, the electric assembly 1 further includes a negative output copper bus bar 510. The negative output copper bus bar 510 is shared by the first capacitor 500 and the second capacitor 600. In this way, there is no need to additionally arrange the negative output copper bus bar 510 separately for the first capacitor 500 or the second capacitor 600, which reduces the number of components and reduces production costs, thereby helping reduce the volume of the electric assembly 1.

A negative copper bus bar of the first capacitor 500 may be connected to a negative copper bus bar of a direct-current bus, and a positive copper bus bar of the second capacitor 600 may be connected to a positive copper bus bar of the direct-current bus.

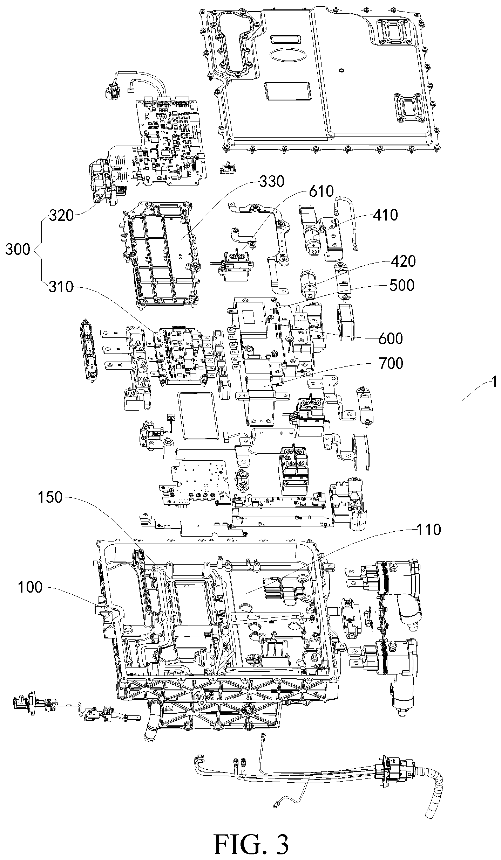

According to some specific embodiments of the present disclosure, as shown in FIG. 3, FIG. 4, FIG. 11, and FIG. 12, the electric assembly 1 further includes a boost capacitor 700. The boost capacitor 700 is mounted in the electric control cavity 110. The boost capacitor 700 is located on a side of the first capacitor 500 facing away from the second capacitor contactor 610 in the second direction. One end 7001 of the boost capacitor 700 is connected to the negative electrode 4002 of the direct-current connector 400, and the other end 7002 of the boost capacitor 700 is connected to the other ends 2102 of the three-phase winding 210. In other words, the two ends of the boost capacitor 700 are respectively connected to a positive electrode and a negative electrode of a charging device (for example, a charging pile or a charging cabinet) that charges the battery pack 2.

The first capacitor 500, the second capacitor 600, and the three-phase winding 210 form an L/C circuit. The boost capacitor 700 can absorb a ripple current, and filter an input current of the charging device, to stabilize a voltage input by the charging device to the electric assembly 1.

According to some specific embodiments of the present disclosure, as shown in FIG. 4, the electric assembly 1 further includes a capacitor housing 3. The first capacitor 500, the second capacitor 600, and the boost capacitor 700 are integrated into the capacitor housing 3.

In this way, the boost capacitor 700, the second capacitor 600, and the first capacitor 500 are closer to each other, and the boost capacitor 700, the second capacitor 600, and the first capacitor 500 can be synchronously disassembled and assembled, so that disassembly and assembly processes are simplified. In addition, the integration of the electric assembly 1 is improved, the volume of the electric control cavity 110 can be smaller, and the volume of the electric assembly 1 is also reduced.

In addition, the negative output copper bus bar 510 and a heat dissipation device can be shared by the first capacitor 500 and the second capacitor 600, thereby facilitating heat dissipation and a connection of a wiring harness, and saving space and costs.

According to some specific embodiments of the present disclosure, as shown in FIG. 4, a number of wire harness fixing grooves 910 are provided on the capacitor housing 3, and the number of wire harness fixing grooves 910 are at least partially provided above the second capacitor 600. In other words, a number of wire harness fixing grooves 910 may be provided above the second capacitor 600. A wire harness connected to the second capacitor 600 is led out from the second capacitor 600 and then may pass through a wire harness fixing groove 910. The wire harness fixing groove 910 may fix the part of the wire harness, so that the wire harness connected to the second capacitor 600 is more tidy, and positional interference between the wire harness and other components is avoided, thereby further facilitating an overall layout of the electric assembly 1.

According to some specific embodiments of the present disclosure, as shown in FIG. 4, a number of cable tie holes 920 are provided on the capacitor housing 3, and the cable tie holes 920 are at least partially provided above the boost capacitor 700. In other words, a number of cable tie holes 920 may be provided above the boost capacitor 700. A wire harness connected to the boost capacitor 700 is led out from the boost capacitor 700 and then may be fixed by a cable tie passing through a cable tie hole 920. The cable tie passing through the cable tie hole 920 may fix the part of the wire harness, so that the wire harness connected to the boost capacitor 700 may be more tidy, and positional interference between the wire harness and other components is avoided, thereby further facilitating the overall layout of the electric assembly 1.

According to some specific embodiments of the present disclosure, as shown in FIG. 3, FIG. 11, and FIG. 12, the electric assembly 1 further includes a positive fuse 410 and a negative fuse 420.

The positive fuse 410 is mounted in the electric control cavity 110 and located between the first capacitor 500 and the direct-current connector 400 in the first direction. One end 4101 of the positive fuse 410 is connected to the positive electrode 4001 of the direct-current connector 400, and the other end 4102 of the positive fuse 410 is connected to the upper bridge arm 351 of each phase bridge arm 350. The positive fuse 410 is arranged, so that no short circuit occurs between a part of a backflow current of the battery pack 2 in a self-heating process and a current on a positive electrode of the battery pack 2, thereby improving safety of the electrical connection of the electric assembly 1.

The negative fuse 420 is mounted in the electric control cavity 110 and located between the first capacitor 500 and the direct-current connector 400 in the first direction. The negative fuse 420 is located below the positive fuse 410. One end 4201 of the negative fuse 420 is connected to the negative electrode 4002 of the direct-current connector 400, and the other end 4202 of the negative fuse 420 is connected to the lower bridge arm 352 of each phase bridge arm 350. The negative fuse 420 is arranged, so that a driving current of the battery pack 2 to the bridge arm 350 is not excessively large, thereby driving the fuse.

For example, the positive fuse 410 and the negative fuse 420 may be mounted on the capacitor housing 3, so that a layout between the positive fuse 410 and the negative fuse 420 is more hierarchical, the volume of the electric control cavity 110 is not increased in the first direction and the second direction, that is, a cross-sectional area of the electric control cavity 110 is not affected, and arrangement of components in the electric control cavity 110 is more compact. In this way, the integration of the electric assembly 1 is improved, and the volume of the electric control cavity 110 can be smaller.

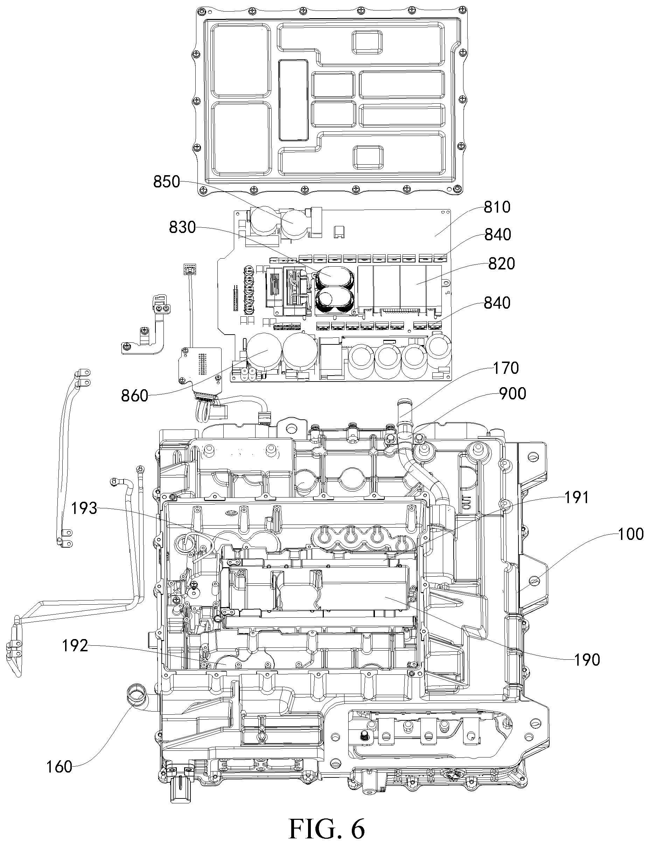

According to some specific embodiments of the present disclosure, as shown in FIG. 6 to FIG. 8, the electric assembly 1 further includes a power supply module 800. The box 100 further includes a power supply cavity 190. The power supply cavity 190 is provided below the electric control cavity 110, and the power supply module 800 is arranged in the power supply cavity 190. The control board 320 may be connected to and be in communication with a vehicle controller and the power supply module 800. The control board 320 outputs a control signal according to an electrical signal of the vehicle controller, to control the driving board 310 and the power supply module 800.

In other words, the power supply cavity 190 and the electric control cavity 110 are respectively arranged on two opposite sides of the box 100 in a thickness direction, so that the power supply module 800 is unlikely to interfere with the electric control module 300 in the electric control cavity 110. In addition, the power supply cavity 190 is provided below the electric control cavity 110, and the power supply module 800 is located on a side of the IGBT module 340 away from the control board 320. In this way, the power supply module 800 is farther away from the control board 320, and the power supply module 800 and the control board 320 are spaced by the shielding plate 330, so that electromagnetic interference generated by the power supply module 800 to the control board 320 can be further reduced, and control of the electric assembly 1 is more reliable and stable.

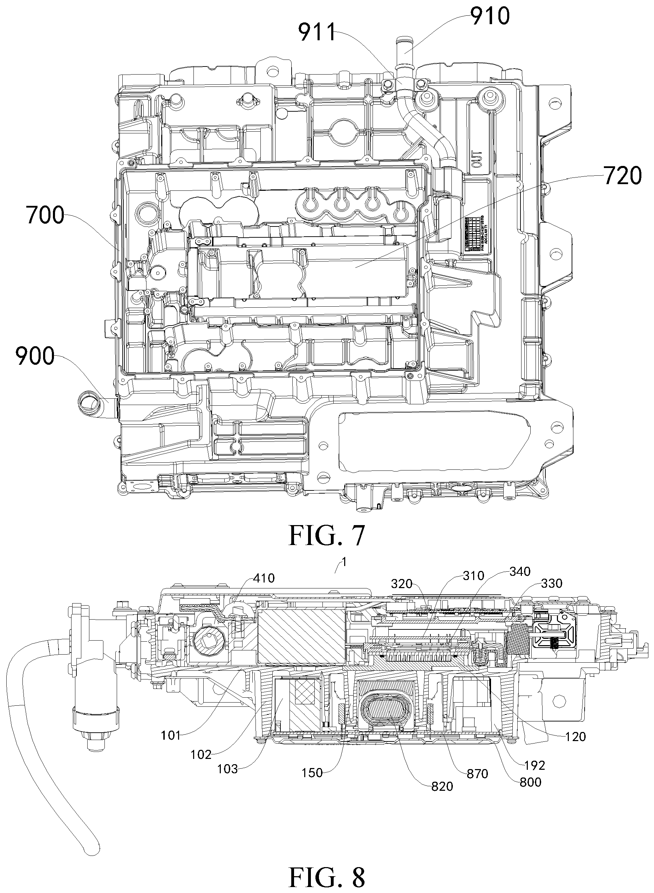

According to some specific embodiments of the present disclosure, as shown in FIG. 8, a bracket 101 is arranged in the box 100. The bracket 101 divides the box 100 into the electric control cavity 110 located on an upper part and the power supply cavity 190 located on a lower part. A number of shielding ribs 102 extending facing the power supply cavity 190 are arranged on the bracket 101. The shielding ribs 102 form a shielding cavity 103. The shielding cavity 103 is configured to mount devices forming the power supply module 800.

Therefore, the bracket 101 can isolate the electric control cavity 110 from the power supply cavity 190, and make the electric control cavity 110 and the power supply cavity 190 integrated into the same box 100, so that the integration is higher. In addition, the bracket 101 can avoid interference between components in the electric control cavity 110 and components in the power supply cavity 190.

In addition, the number of shielding ribs 102 may be arranged, and the number of shielding ribs 102 may divide the power supply cavity 190 into a number of shielding cavities 103. In this way, the number of shielding cavities 103 can separately accommodate the devices forming the power supply module 800, to avoid electromagnetic interference between the number of devices forming the power supply module 800, thereby ensuring normal operation of the power supply module 800. In addition, the shielding cavities 103 can also be configured to fix the devices in the power supply module 800, to improve mounting stability of the power supply module 800.

According to some embodiments of the present disclosure, as shown in FIG. 6 and FIG. 8, the box 100 further includes a bottom plate 810. The bottom plate 810 is configured to block an opening below the power supply cavity 190. In this way, the bottom plate 810 can block the power supply cavity 190, so that the power supply module 800 is fixed between the power supply cavity 190 and the bottom plate 810, tightness of the power supply cavity 190 is further improved, and fixing of the bottom plate 810 for the power supply module 800 is more reliable. In addition, the bottom plate 810 can also have a shielding function, thereby shielding interference of the power supply module 190 with the outside.

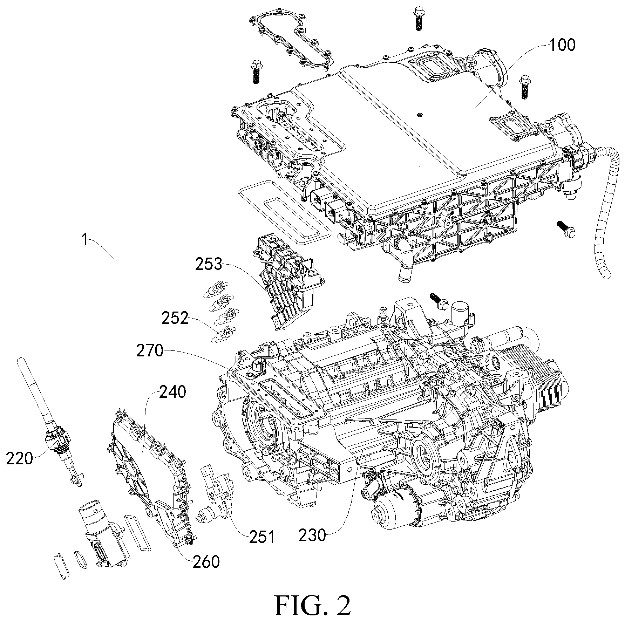

According to some specific embodiments of the present disclosure, as shown in FIG. 2, the motor 200 includes a casing 230 and an end cover 240.

The three-phase winding 210 is arranged in the casing 230. The end cover 240 is arranged at one end of the casing 230 and is configured to block the casing 230. An opening 260 for the N-line connecting assembly 250 to pass through is provided on the end cover 240. An N-line nose 220 is connected to the one end 2101 of the three-phase winding 210 through the N-line connecting assembly 250.

In this way, the N-line connecting assembly 250 can extend out of the opening 260 and be connected to the N-line nose 220; and a conductive structure connected to the junction end of the three-phase winding 210 and the battery pack 2 does not need to pass through the box 100, a wiring path between the junction end of the three-phase winding 210 and the battery pack 2 is shorter, and the junction end of the three-phase winding 210 and the battery pack 2 can conduct electricity through a connecting wire of the N-line nose 220, so that the conductive structure between the junction end of the three-phase winding 210 and the battery pack 2 is simpler.

In addition, the N-line connecting assembly 250 can extend out of the opening 260 and be connected to the battery pack 2 through the N-line nose 220. Therefore, the N-line connecting assembly 250 does not need to extend into the box 100, so that a volume of the box 100 can be reduced. In addition, the N-line connecting assembly 250 does not interfere with the electric control module 300 in the box 100, thereby facilitating the layout in the box 100.

According to some specific embodiments of the present disclosure, as shown in FIG. 2, the N-line connecting assembly 250 includes an N-line adapter 251, an N line 252, an N-line socket 253, and an N-line nose 220.

One end of the N line 252 is connected to the one end 2101 of the three-phase winding 210. One end of the N-line adapter 251 is connected to the one end of the N line 252. The other end of the N-line adapter 251 passes through the opening 260 and is connected to one end of the N-line nose 220. One end of the N-line socket 253 is connected to the other end of the N line 252, and the other end of the N-line socket 253 extends into the box 100 to be connected to an N-line copper bus bar 3001 of the electric control module 300. The N-line copper bus bar 3001 passes through a Hall 3002. The Hall 3002 is connected to the electric control module 300 through a signal cable.

The N-line adapter 251 is arranged to facilitate a connection between the junction end of the three-phase winding 210 and the N-line nose 220, and the N-line 252 and the N-line socket 253 are arranged to implement a connection between the three-phase winding 210 and a charging base of the vehicle. In this way, when the charging base is connected to a charging box with a low charging voltage (for example, the charging voltage is 450 V), a charging current can be guided to the three-phase winding 210 and the bridge arm 350 through the N-line 252 and the N-line socket 253, and flow to the battery pack 2 through the bridge arm 350, thereby implementing boost charging of the battery pack 2.

According to some specific embodiments of the present disclosure, as shown in FIG. 2, an insertion groove 270 is provided at the one end of the casing 230 close to the end cover 240. The insertion groove 270 is provided close to the electric control cavity 110. The N-line socket 253 is inserted into the insertion groove 270 and fixedly connected to the casing 230. In this way, the N-line socket 253 is fixed to the casing 230, and the N-line socket 253 is closer to the other end of the N-line 252 and the N-line copper bus bar 3001 of the electric control module 300 is closer, so that a volume of the N-line socket 253 can be smaller.

According to some specific embodiments of the present disclosure, as shown in FIG. 4 and FIG. 8 to FIG. 10, the electric assembly 1 further includes a liquid channel cover plate 120. The liquid channel cover plate 120 is provided with a first liquid channel 130. The electric control cavity 110 is provided with a second liquid channel 140 and a third liquid channel 150. The liquid channel cover plate 120 is connected to the box 100 and blocks the second liquid channel 140 and the third liquid channel 150. The liquid channel cover plate 120 may be integrally connected to the box 100 by friction welding.

The first liquid channel 130 is in communication with the second liquid channel 140 and the third liquid channel 150. The second liquid channel 140 is adapted to communicate with a liquid inlet pipe 160, and the third liquid channel 150 is adapted to communicate with a liquid outlet pipe 170. A coolant in the second liquid channel 140 flows into the first liquid channel 130, to dissipate heat for the IGBT module 340; and the coolant in the first liquid channel 130 flows into the third liquid channel 150, to dissipate heat for the power supply module 800.

In other words, the first liquid channel 130, the second liquid channel 140, and the third liquid channel 150 form a communicating liquid channel, and the coolant in the first liquid channel 130, the second liquid channel 140, and the third liquid channel 150 may be shared. The IGBT module may seal the first liquid channel 130, thereby avoiding leakage of the coolant in the first liquid channel 130. In addition, the coolant in the first liquid channel 130 may cool down the IGBT module 340, to avoid damage to the IGBT module 340 at a high temperature, so that the IGBT module 340 is in a low-temperature state or a normal-temperature state, thereby maintaining operating stability of the IGBT module.

In addition, the liquid channel cover plate 120 may seal the second liquid channel 140 and the third liquid channel 150, thereby avoiding leakage of the coolant in the second liquid channel 140 and the third liquid channel 150. In addition, the coolant in the third liquid channel 150 may exchange heat with the power supply module 800 through an outer wall of the third liquid channel 150, so that a temperature of the power supply module 800 can be reduced, and the power supply module 800 can be maintained in a low-temperature state or a normal-temperature state, thereby improving operating stability of the power supply module 800, and avoiding damage to the power supply module 800 at a high temperature.

In addition, the first liquid channel 130, the second liquid channel 140, and the third liquid channel 150 are in communication, so that a flow path of the coolant is longer. The coolant in the second liquid channel 140 may flow into the first liquid channel 130, to dissipate heat for the IGBT module 340; and the coolant in the first liquid channel 130 may also flow into the third liquid channel 150, to dissipate heat for the power supply module 800, so that utilization of the coolant can be improved, and the coolant can fully exchange heat with the power supply module 800 and the IGBT module 340.

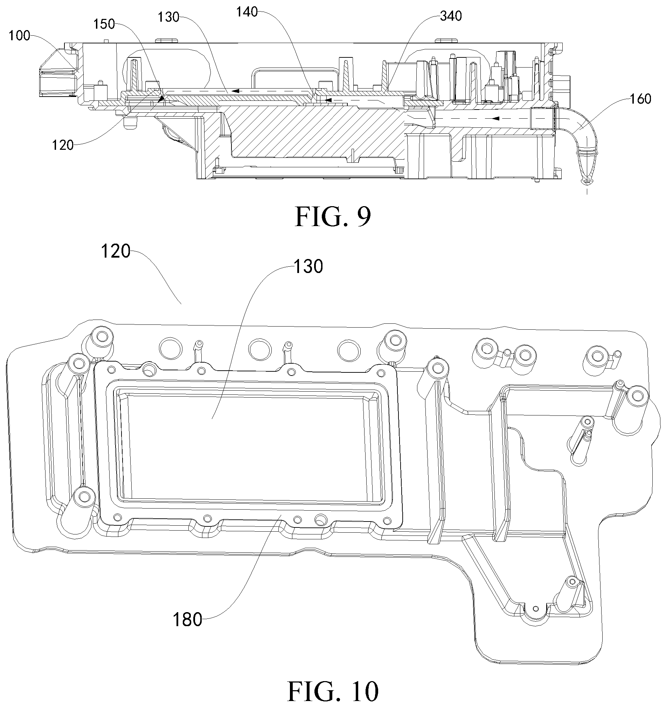

According to some specific embodiments of the present disclosure, as shown in FIG. 9 and FIG. 10, the electric assembly 1 further includes a sealing ring 180. A sealing groove surrounding the first liquid channel 130 is provided on the liquid channel cover plate 120. The sealing ring 180 is arranged in the sealing groove. The IGBT module 340 compresses the sealing ring 180, and the sealing ring 180 fills a gap between the liquid channel cover plate 120 and the IGBT module.

In this way, the IGBT module 340 can better seal the first liquid channel 130, thereby further improving sealing performance of the first liquid channel 130, and more effectively avoiding leakage of the coolant in the first liquid channel 130.

According to some specific embodiments of the present disclosure, as shown in FIG. 4, the third liquid channel 150 includes a transition section 151 and an annular section 152. The transition section 151 is in communication with the first liquid channel 130. The annular section 152 surrounds the power supply module 800 and dissipates heat for the power supply module 800. One end of the annular section 152 is connected to the other end of the transition section 151, and a liquid outlet hole 1521 is provided at the other end of the annular section 152. A depth of the annular section 152 is greater than a depth of the second liquid channel 140 and a depth of the transition section 151.

For example, the coolant first flows into the second liquid channel 140 and then flows into the first liquid channel 130; and then the coolant in the first liquid channel 130 flows to the transition section 151, and finally flows from the transition section 151 to the annular section 152, to be discharged out from the liquid outlet hole 1521 of the annular section 152. In addition, a contact area between the annular section 152 and the power supply module 800 is larger, and the annular section 152 has a more compact structure and occupies less space. When the annular section 152 is used to dissipate heat for the power supply module 800, a heat exchange effect between the third liquid channel 150 and the power supply module 800 can be improved, so that the power supply module 800 can be quickly cool down, and the heat dissipation effect is better.

In addition, the depth of the annular section 152 is greater than the depth of the second liquid channel 140 and the depth of the transition section 151. In this way, a volume of the annular section 152 can be larger, and more coolant can be provided in the annular section 152, thereby improving a heat dissipation effect of the annular section 152 on the power supply module 800. In addition, a transition between the second liquid channel 140 and the first liquid channel 130 can be gentler, a transition between the transition section 151 and the first liquid channel 130 can be gentler, and the coolant circulates more gently between the third liquid channel 150 and the first liquid channel 130, so that the coolant can fully exchange heat with the power supply module 800 and the IGBT module, thereby further improving the heat dissipation effect on the power supply module 800 and a heat dissipation effect on the IGBT module 340.

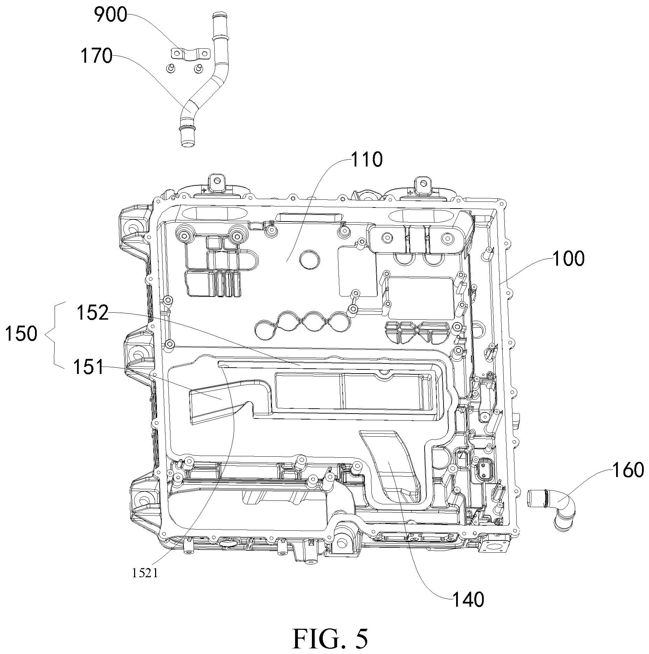

In some specific embodiments of the present disclosure, as shown in FIG. 5, the electric assembly 1 further includes the liquid inlet pipe 160 and the liquid outlet pipe 170. The liquid inlet pipe 160 is mounted in the box 100 and is in communication with the second liquid channel 140. The liquid outlet pipe 170 is mounted in the box 100 and is in communication with the liquid outlet hole 1521. The liquid inlet pipe 160 and the liquid outlet pipe 170 are arranged perpendicular to each other.

In this way, the coolant may flow into the second liquid channel 140, the first liquid channel 130, and the third liquid channel 150 from the liquid inlet pipe 160, and the coolant may be discharged out from the liquid outlet hole 1521 and the liquid outlet pipe 170. In other words, after the coolant fully exchanges heat with the power supply module 800 and the IGBT module 340, the coolant in the second liquid channel 140, the first liquid channel 130, and the third liquid channel 150 may be discharged out from the liquid outlet pipe 170, and the coolant is replenished for the second liquid channel 140, the first liquid channel 130, and the third liquid channel 150 through the liquid inlet pipe 160, to keep the coolant in the second liquid channel 140, the first liquid channel 130, and the third liquid channel 150 sufficient, and keep a temperature of the coolant low, thereby improving a cooling effect of the third liquid channel 150 and the first liquid channel 130 on the power supply module 800 and the IGBT module 340.

In addition, the liquid inlet pipe 160 and the liquid outlet pipe 170 are arranged perpendicular to each other. For example, the liquid inlet pipe 160 may be arranged on a side of the box 100, and the liquid outlet pipe 170 may be arranged on an adjacent side of the box 100. In this way, positional interference between the liquid inlet pipe 160 and the liquid outlet pipe 170 can be avoided, thereby facilitating arrangement. In addition, lengths of the third liquid channel 150 and the first liquid channel 130 can be set to be longer, so that the third liquid channel 150 and the first liquid channel 130 can cover most part of the box 100, thereby further improving the cooling effect of the third liquid channel 150 and the first liquid channel 130 on the power supply module 800 and the IGBT module 340. In addition, the coolant in the third liquid channel 150 and the first liquid channel 130 can reduce a temperature of the box 100, so that heat can also be dissipated for other components mounted in the box 100, thereby improving a heat dissipation effect of the box 100.

For example, as shown in FIG. 5 and FIG. 7, the foregoing arrangement causes the liquid outlet pipe 170 to be longer. Therefore, a pressing plate 900 may be added. The pressing plate 900 is mounted on the box 100, and clamps the liquid outlet pipe 170 together with the box 100, to fix a position of the liquid outlet pipe 170 relative to the box 100.

According to some specific embodiments of the present disclosure, as shown in FIG. 6 to FIG. 8, the power supply module 800 includes a power supply power board 870. The power supply power board 870 is mounted in the power supply cavity 190. A number of devices are mounted on the power supply power board 870. The number of devices include a transformer 820, a transformer inductor 830, an AC inductor 850, a DC inductor 860, and a number of MOS transistors 840.

The transformer 820 and the transformer inductor 830 are arranged spaced away. The number of MOS transistors 840 are respectively arranged on two opposite sides of the transformer 820 and the transformer inductor 830. The AC inductor 850 and the DC inductor 860 are respectively arranged on the two opposite sides of the transformer 820 and the transformer inductor 830. The third liquid channel 150 surrounds the transformer 820 and the transformer inductor 830. The number of MOS transistors 840 are located on two opposite sides of the third liquid channel 150 and exchange heat with the third liquid channel 150.

In this way, the third liquid channel 150 surrounds the transformer 820 and the transformer inductor 830, the number of MOS transistors 840 are located outside the third liquid channel 150 and are attached to the outer wall of the third liquid channel 150, and the third liquid channel 150 can be used to dissipate heat for the transformer 820, the transformer inductor 830, the number of MOS transistors 840, the AC inductor 850, and the DC inductor 860, thereby improving heat dissipation efficiency of the power supply module 800.

In addition, the AC inductor 850 and the DC inductor 860 are respectively arranged on the two opposite sides of the third liquid channel 150. In this way, the transformer inductor 830, the AC inductor 850, and the DC inductor 860 are spaced by side walls of the third liquid channel 150, thereby reducing a probability and impact of electromagnetic interference among the transformer inductor 830, the AC inductor 850, and the DC inductor 860, and improving control reliability of the electric assembly 1.

According to some specific embodiments of the present disclosure, as shown in FIG. 6 and FIG. 7, the power supply cavity 190 is provided with a number of MOS transistor cavities 191, an AC inductor cavity 192, and a DC inductor cavity 193. The AC inductor 850 extends into the AC inductor cavity 192. The DC inductor 860 extends into the DC inductor cavity 193. The number of MOS transistors 840 extend into the number of MOS transistor cavities 191 in a one-to-one correspondence. In this way, electromagnetic interference among the number of MOS transistors 840, the AC inductor 850, the DC inductor 860, and the transformer inductor 830 is further avoided, and interference with external electronic devices can also be avoided, thereby helping improve electromagnetic compatibility.

A vehicle 1000 according to an embodiment of the present disclosure is described below with reference to FIG. 13. The vehicle 1000 includes the electric assembly 1 according to the foregoing embodiments of the present disclosure.

In the vehicle 1000 according to this embodiment of the present disclosure, the electric assembly 1 according to the foregoing embodiments of the present disclosure is used, so that self-heating of battery packs 2 can be implemented, and a three-phase winding 210 of a motor 200 and bridge arms 350 of an electric control module 300 are also reused in self-heating circuits of the battery packs 2, which have advantages such as low costs, a small volume, and a small number of components.

Other forming and operations of the electric assembly 1 and the vehicle provided with same according to the embodiments of the present disclosure are known to a person of ordinary skill in the art, and are not described in detail herein.

In the description of this specification, descriptions using reference terms "an embodiment", "some embodiments", "an exemplary embodiment", "an example", "a specific example", or "some examples" mean that specific characteristics, structures, materials, or features described with reference to the embodiment or example are included in at least one embodiment or example of the present disclosure. In this specification, schematic descriptions of the foregoing terms do not necessarily point at a same embodiment or example.

Although the embodiments of the present disclosure have been shown and described, a person of ordinary skill in the art should understand that various changes, modifications, replacements and variations may be made to the embodiments without departing from the principles and spirit of the present disclosure, and the scope of the present disclosure is as defined by the appended claims and their equivalents.

## Claims

1. An electric assembly (1), comprising:
a box (100), comprising an electric control cavity (110);
an N-line connecting assembly (250), one end (2501) of the N-line connecting assembly (250) being adapted to connect between two battery packs (2) connected in series;
a motor (200), comprising a three-phase winding (210), one end (2101) of the three-phase winding (210) being a junction end, and the junction end being connected to another end (2502) of the N-line connecting assembly (250); and
an electric control module (300), mounted in the electric control cavity (110), and comprising:
an insulated gate bipolar transistor (IGBT) module (340), comprising a three-phase bridge arm (350), other ends (2102) of the three-phase winding (210) being respectively connected to a midpoint of the three-phase bridge arm (350); and
a direct-current connector (400), a positive electrode (4001) of the direct-current connector (400) being connected to the junction end, and a negative electrode (4002) of the direct-current connector (400) being connected to the IGBT module (340) and being adapted to connect to negative electrodes of the battery packs (2).

2. The electric assembly (1) according to claim 1, further comprising:
a first capacitor (500), mounted in the electric control cavity (110) and being an X capacitor, one end (5001) of the first capacitor (500) being connected to the positive electrode (4001) of the direct-current connector (400), and the other end (5002) of the first capacitor (500) being connected to the negative electrode (4002) of the direct-current connector (400).

3. The electric assembly (1) according to claim 2, further comprising:
a second capacitor (600), mounted in the electric control cavity (110) and being an X capacitor, one end (6001) of the second capacitor (600) being connected to the one end (5001) of the first capacitor (500), and the other end (6002) of the second capacitor (600) being connected to the positive electrode (4001) of the direct-current connector (400); and
a second capacitor contactor (610), mounted in the electric control cavity (110), one end (6101) of the second capacitor contactor (610) being connected to the one end (6001) of the second capacitor (600), and the other end (6102) of the second capacitor contactor (610) being connected to the one end (2101) of the three-phase winding (210).

4. The electric assembly (1) according to claim 3, further comprising:
a boost capacitor (700), mounted in the electric control cavity (110), one end (7001) of the boost capacitor (700) being connected to the negative electrode (4002) of the direct-current connector (400), and the other end (7002) of the boost capacitor (700) being connected to the other ends (2102) of the three-phase winding (210).

5. The electric assembly (1) according to claim 4, further comprising:
a capacitor housing (3), the first capacitor (500), the second capacitor (600), and the boost capacitor (700) being integrated into the capacitor housing (3).

6. The electric assembly (1) according to claim 5, further comprising:
a negative output copper bus bar (510), mounted in the capacitor housing (3), the negative output copper bus bar (510) being shared by the first capacitor (500) and the second capacitor (600).

7. The electric assembly (1) according to claim 5 or 6, wherein a plurality of wire harness fixing grooves (910) are provided on the capacitor housing (3), and the plurality of wire harness fixing grooves (910) are at least partially provided above the second capacitor (600).

8. The electric assembly (1) according to any one of claims 1 to 7, further comprising:
a positive fuse (410), mounted in the electric control cavity (110), one end (4101) of the positive fuse (410) being connected to the positive electrode (4001) of the direct-current connector (400), and the other end (4102) of the positive fuse (410) being connected to an upper bridge arm (351) of each phase bridge arm (350); and
a negative fuse (420), mounted in the electric control cavity (110) and located below the positive fuse (410), one end (4201) of the negative fuse (420) being connected to the negative electrode (4002) of the direct-current connector (400), and the other end (4202) of the negative fuse (420) being connected to a lower bridge arm (352) of each phase bridge arm (350).

9. The electric assembly (1) according to any one of claims 1 to 8, further comprising:
a power supply module (800), the box (100) further comprising a power supply cavity (190), the power supply cavity (190) being provided below the electric control cavity (110), and the power supply module (800) being arranged in the power supply cavity (190).

10. The electric assembly (1) according to claim 9, wherein a bracket (101) is arranged in the box (100), the bracket (101) divides the box (100) into the electric control cavity (110) on an upper part and the power supply cavity (190) on a lower part, a plurality of shielding ribs (102) extending facing the power supply cavity (190) are arranged on the bracket (101), the shielding ribs (102) form a shielding cavity (103), and the shielding cavity (103) is configured to mount devices forming the power supply module (800).

11. The electric assembly (1) according to claim 9 or 10, wherein the box (100) further comprises a bottom plate (810), configured to block an opening (260) below the power supply cavity (190).

12. The electric assembly (1) according to any one of claims 1 to 11, wherein the motor (200) comprises:
a casing (230), the three-phase winding (210) being arranged in the casing (230); and
an end cover (240), arranged at one end of the casing (230) and configured to block the casing (230), an opening (260) for the N-line connecting assembly (250) to pass through being provided on the end cover (240).

13. The electric assembly (1) according to claim 12, wherein the N-line connecting assembly (250) comprises:
an N line (252), one end of the N line (252) being connected to the one end (2101) of the three-phase winding (210);
an N-line adapter (251), one end of the N-line adapter (251) being connected to the one end of the N line (252);
an N-line nose (220), the other end of the N-line adapter (251) passing through the opening (260) and being connected to one end of the N-line nose (220); and
an N-line socket (253), one end of the N-line socket (253) being connected to the other end of the N line (252), the other end of the N-line socket (253) being connected to an N-line copper bus bar (3001) of the electric control module (300), the N-line copper bus bar (3001) passing through a Hall (3002), and the Hall (3002) being connected to the electric control module (300) through a signal cable.

14. The electric assembly (1) according to claim 13, wherein an insertion groove (260) is provided at the one end of the casing (230) close to the end cover (240), the insertion groove (260) is provided close to the electric control cavity (110), and the N-line socket (253) is inserted into the insertion groove (260) and fixedly connected to the casing (230).

15. The electric assembly (1) according to any one of claims 9 to 11, further comprising:
a liquid channel cover plate (120), provided with a first liquid channel (130), the electric control cavity (110) being provided with a second liquid channel (140) and a third liquid channel (150), the liquid channel cover plate (120) being connected to the box (100) and blocking the second liquid channel (140) and the third liquid channel (150), the first liquid channel (130) being in communication with the second liquid channel (140) and the third liquid channel (150), the second liquid channel (140) being adapted to communicate with a liquid inlet pipe (160), and the third liquid channel (150) being adapted to communicate with a liquid outlet pipe (170),
wherein a coolant in the second liquid channel (140) flows into the first liquid channel (130), to dissipate heat for the IGBT module (340); and the coolant in the first liquid channel (130) flows into the third liquid channel (150), to dissipate heat for the power supply module (800).

16. The electric assembly (1) according to claim 15, further comprising:
a sealing ring (180), a sealing groove surrounding the first liquid channel (130) being provided on the liquid channel cover plate (120), the sealing ring (180) being arranged in the sealing groove, the IGBT module (340) compressing the sealing ring (180), and the sealing ring (180) filling a gap between the liquid channel cover plate (120) and the IGBT module (340).

17. The electric assembly (1) according to claim 15 or 16, wherein the third liquid channel (150) comprises:
a transition section (151), the transition section (151) being in communication with the first liquid channel (130); and
an annular section (152), surrounding the power supply module (800) and dissipating heat for the power supply module (800), one end of the annular section (152) being connected to the other end of the transition section (151), and a liquid outlet hole (1521) being provided at the other end of the annular section (152),
wherein a depth of the annular section (152) is greater than a depth of the second liquid channel (140) and a depth of the transition section (151).

18. The electric assembly (1) according to any one of claims 15 to 17, wherein the power supply module (800) comprises a power supply power board (870), mounted in the power supply cavity (190), a plurality of devices being mounted on the power supply power board (870); and
the plurality of devices comprise:
a transformer (820);
a transformer inductor (830), the transformer inductor (830) and the transformer (820) being arranged spaced away;
a plurality of MOS transistors (840), respectively arranged on two opposite sides of the transformer (820) and the transformer inductor (830);
an AC inductor (850); and
a DC inductor (860), the DC inductor (860) and the AC inductor (850) being respectively arranged on the two opposite sides of the transformer (820) and the transformer inductor (830),
wherein the third liquid channel (150) surrounds the transformer (820) and the transformer inductor (830), and the plurality of MOS transistors (840) are located on two opposite sides of the third liquid channel (150) and exchange heat with the third liquid channel (150).

19. The electric assembly (1) according to claim 18, wherein the power supply cavity (190) is provided with a plurality of MOS transistor (840) cavities (191), an AC inductor cavity (192), and a DC inductor cavity (193), the AC inductor (850) extends into the AC inductor cavity (192), the DC inductor (860) extends into the DC inductor cavity (193), and the plurality of MOS transistors (840) extend into the plurality of MOS transistor cavities (191) in a one-to-one correspondence.

20. The electric assembly (1) according to any one of claims 1 to 19, wherein the electric control module (300) further comprises:
a control board (320); and
a driving board (310), arranged below the control board (320),
wherein the IGBT module (340) is arranged on the driving board (310), and the IGBT module (340) is connected to the control board (320); and
wherein the electric assembly (1) further comprises:
a shielding plate (330), arranged between the driving board (310) and the control board (320).

21. A vehicle (1000), comprising the electric assembly (1) according to any one of claims 1 to 20.
